# EUROPEAN PATENT SPECIFICATION

(11) **EP 1 420 928 B1**
(45) Date of publication and mention of the grant of the patent: **20.07.2005**
(21) Application number: 02763567.1
(22) Date of filing: 29.08.2002
(51) Int. Cl.: B29B 13/10, B02C 19/12

(54) **GRINDING OF LIQUID CRYSTALLINE POLYMERS**
SCHLEIFEN VON FLÜSSIGKRISTALLINENPOLYMEREN
BROYAGE DE POLYMERES CRISTALLINS LIQUIDES

(30) Priority: 30.08.2001 US 315885 P; 30.08.2001 US 315890 P
(43) Date of publication of application: 26.05.2004
(73) Proprietor: E.I. DU PONT DE NEMOURS AND COMPANY, Wilmington, Delaware 19898 (US)
(72) Inventor: SAMUELS, Michael, R., Wilmington, DE 19808 (US)
(74) Representative: Abitz, Walter, Dr.-Ing.
(86) International application number: PCT/US2002/027544
(87) International publication number: WO 2003/020484

(56) References cited:
- DE-B- 1 128 120
- US-A- 5 100 605
- PATENT ABSTRACTS OF JAPAN vol. 012, no. 398 (C-538), 21 October 1988 (1988-10-21) & JP 63 139921 A (UNITIKA LTD), 11 June 1988 (1988-06-11)

## Description

### FIELD OF THE INVENTION

Thermotropic liquid crystalline polymers are readily ground to smaller particle sizes by using a two or more stage grinding process.

### TECHNICAL BACKGROUND

Thermoplastic polymers which are in fine particle form are often desired for uses such as papermaking and making nonwoven cloth and other structures. Most polymers can be ground by conventional methods, although some polymers are ground most readily if they are cooled, for example to dry ice or liquid nitrogen temperatures. Thermotropic liquid crystalline polymers (LCPs) are more difficult to grind to small particles because of their inherently fibrous nature. Such LCPs usually have oriented domains in the solid state, and when such domains are broken up they form smaller domains (particles) which are also oriented. No matter how much these domains are broken up they retain their orientation, and eventually come to resemble short stiff fibers, although these fibrous materials do not necessarily have round cross sections.

As these fibrous materials are formed, for example from pellets of LCP, they tend to form clumps which other hinder the grinding action of the apparatus which is breaking up the LCP particles. Although breakdown of the LCPs will still take place, the process becomes very slow and inefficient, see for instance U.S. Patent 5,100,605.

U.S. Patent 5,100,605 describes the grinding of a (largely) isotropic LCP formed by extruding the LCP at or near its so-called clearing temperature (temperature above which it is no longer liquid crystalline). In an example a two stage grinding process is described. The present invention concerns grinding LCPs which are anisotropic.

U.S. Patent 6,174,405 describes grinding of low molecular weight LCP (essentially "prepolymers") to powders. No mention is made of a two stage grinding process.

U.S. Patent 5,922,453 and Japanese Patent Application 8-13245 describe the grinding of LCPs to smaller particle materials. No mention is made of multistage grinding processes in these references.

Japanese Patent Application Publication 63139921 describes a process to facilitate the formation of a powder comprising a liquid crystal polymer without formation of fibrils, by grinding nonoriented lumps comprising a polymer which can form an anisotropic melt by application of an impact at a specified temperature or below.

DE 1,128,120 describes a process for facilitating the grinding operation of polyesters, wherein the polyester melt is cooled to a temperature in the range of 80° to 100°C and grinded within that temperature range and then hot packaged in air tight containers.

It is the object of the present invention to provide a simple process for grinding LCPs without encountering the problems described above in connection with U.S. Patent 5,100,605.

### SUMMARY OF THE INVENTION

The present invention is defined in the claims. It has now been found that two or more stage grinding processes are much more efficient in reducing LCPs to relatively small particles.

This invention concerns, a process for forming small particles from larger particles of an anisotropic thermotropic liquid crystalline polymer, comprising:
(a) grinding said anisotropic thermotropic liquid crystalline polymer in a first grinding apparatus;
(b) removing said anisotropic thermotropic liquid crystalline polymer from said first grinding apparatus;
(c) grinding said anisotropic thermotropic liquid crystalline polymer from (b) in a second grinding apparatus; and
(d) removing said anisotropic thermotropic liquid crystalline polymer from said second grinding apparatus.

Particular embodiments of the invention are the subject of the dependent claims.

### DETAILS OF THE INVENTION

Herein certain terms are used, and some of them are:
By a "grinding apparatus" is meant any apparatus which can exert enough shearing and/or crushing force to cause the material being ground (usually an LCP) to be broken into smaller pieces. Such apparatuses includes hammermills including disintegrators and pin mills, disc mills, fluidized bed air-jet mills, jaw crushers, gyratory crushers, cage mills, pan crushers, ball, pebble rod and tube mills, disk attrition mills, attritors, disc refiners, etc.
By "LCP" is meant a polymer which is anisotropic when tested by the TOT test as described in U.S. Patent No. 4,118,372. By thermotropic is meant the LCP may be melted and is anisotropic in the melt, as described in the TOT test. Herein "LCP" includes blends of LCPs with other polymers, so long as the LCP is at least about 50 weight percent of the polymer blend, based on the total amount of polymer in the blend.
By "anisotropic" herein is meant that the LCP in the solid form (to be ground) is oriented. This may be tested by grinding the LCP particles. If the LCP is anisotropic, when small enough particles are produced they will be fibrous, that is short and fiber-like (although usually stiff) in nature. Preferably the LCP does not have a clearing temperature, that is it decomposes at a temperature before reaching a clearing temperature.
By "grinding" herein is meant reducing solid particles in size using a grinding apparatus (see above).
By "a" or "an" herein, such as when referring to an LCP, is meant one or more.
By "comprising" herein is meant the named items (materials), and any other additional materials or compositions may be present.
By "classified" herein is meant that the ground (at any stage) LCP is separated into classes of particle sizes. These may be a range of sizes, such as 30 to 60 mesh (passing through a 30 mesh screen but retained by a 60 mesh screen), or larger (retained by a 30 mesh screen) or smaller than 30 mesh (passing through a 30 mesh screen). Unless otherwise indicated sieve sizes herein are slotted screens with slots about 1.0 cm long and whose width is equivalent to the opening in a US standard screen of the same nominal mesh size. Preferably after the last grinding stage a majority of the LCP will pass through a 30 mesh screen, more preferably a 60 mesh screen.

By a grinding stage (or step) herein is meant placing the LCP to be ground into a grinding apparatus, reducing the average (mean or median) particle size of the LCP, and removing the LCP from the grinding apparatus.

Herein an LCP is ground. Useful LCPs include those which are described in U.S. Patent Nos. 3,991,013, 3,991,014 4,011,199, 4,048,148, 4,075,262, 4,083,829, 4,118,372, 4,122,070, 4,130,545, 4,153,779, 4,159,365, 4,161,470, 4,169,933, 4,184,996, 4,189,549, 4,219,461, 4,232,143, 4,232,144, 4,245,082, 4,256,624, 4,269,965, 4,272,625, 4,370,466, 4,383,105, 4,447,592, 4,522,974, 4,617,369, 4,664,972, 4,684,712, 4,727,129, 4,727,131, 4,728,714, 4,749,769, 4,762,907, 4,778,927, 4,816,555, 4,849,499, 4,851,496, 4,851,497, 4,857,626, 4,864,013, 4,868,278, 4,882,410, 4,923,947, 4,999,416, 5,015,721, 5,015,722, 5,025,082, 5,086,158, 5,102,935, 5,110,896, 5,143,956, and 5,710,237, and European Patent Application 356,226. A preferred form of LCP is an aromatic polyester or aromatic poly(ester-amide), especially an aromatic polyester. By an "aromatic" polymer is meant that all of the atoms in the main chain are part of an aromatic ring, or are functional groups connecting those rings such as ester, amide, or ether (the latter of which may have been part of a monomer used). The aromatic rings may be substituted with other groups such as alkyl groups. Some particularly preferred aromatic polyester LCPs are those found in U.S. Patent Nos. 5,110,896 and 5,710,237. Another preferred LCP is one containing repeat units derived from terephthalic acid, ethylene glycol, and one or both of 4-hydroxybenzoic acid and 6-hydroxy-2-napthoic acid, or any of their chemical equivalents in polymerization reactions.

Besides other polymers, the LCP (composition) may contain other materials normally found in LCP compositions, such as fillers, reinforcing agents, pigments, lubricants, antioxidants, and filler and reinforcing agents are preferred.

Preferably after one, some or all, more preferably all, of the grinding (in any combination) stages the LCP is classified, at least as to larger or smaller than a certain size. In a two stage grinding process it is also preferred that the LCP is classified after or at the end of the first stage. In grinding processes with more than two stages it is also preferred that the LCP be classified after each stage, except for the final stage. Many types of grinders have interchangeable screens or sieves attached to them and materials is not allowed to exit the grinder until it will pass through the screen attached to the grinder. A screen attached to a grinder is not considered herein part of the grinder. This is a form of classification. Alternately material exiting the grinder may simply be sieved to size fractions larger or smaller than a certain sieve sizes and/or into size ranges.

Useful combinations of grinders to be used in the first and second stage grinding operations are shown below.

| First Stage | Second Stage |
|---|---|
| | |
| hammermill | hammermill |
| disc mill | hammermill |
| disc mill | disc mill |

Other combinations may also be used. In preferred combination the apparatus for the first and second stages is the same, differing only by the size of the screen on the exit port of the grinder, being smaller (higher sieve number) in the second stage, or the clearance between the working (grinding) surfaces is made smaller in the second stage. For example in the first stage one can grind to about 5 to about 30 mesh, preferably about 5 to about 15 mesh, while in the second stage one can grind to about 20 to about 100 mesh, preferably about 30 to about 70 mesh. If a third grinding stage is done, it is preferred that the product be ground to about 60 to about 150 mesh. By grinding to (equal to or smaller than) a certain mesh size in this instance means at least about 90 weight percent, more preferably at least about 99 weight percent, of the LCP can pass through a sieve of the desired size. These sieve size ranges overlap. As noted above the average particle size will be reduced in any grinding stage.

Many grinders have adjustments which may be made to them, such as clearance between the grinding surfaces or elements. If the same (type of) grinder is used in more than one grinding stage, changes can be made to these adjustments may be different in different grinding stages. Some of these adjustments often influence the size of the particles which are produced by the grinder, and so the size of the particles produced in that grinding stage are determined, at least part, by these adjustments.

The LCP may be ground dry or wet, that is with or without the presence of a substantial amounts of a liquid, which may also act as a coolant for the grinding process. In addition a liquid such as water may be used as a "carrier" in one or more grinding stages, particularly when it is desired to produce a pulp of the LCP. Such pulps (or water dispersions of LCPs which are ground dry) are particularly useful for forming nonwoven sheets or papers by typical papermaking techniques.

In some instance, especially when the LCP is ground dry, it is preferred to cool the LCP, for example with dry ice or liquid nitrogen. This sometimes allows the grinder to more easily break up the LCP particles which are fed to it.

In the Examples, except as noted, all of the LCP used had the composition as that of Example 4 of U.S. Patent No. 5,110,896 of hydroquinone/4,4'-biphenol/terephthalic acid/2,6-naphthalenedicarboxylic acid/4-hydroxybenzoic acid in molar ratio 50/50/70/30/320.

In the Examples by a "pulp" is meant fibrous material suspended in water.

In the Examples the following apparatus is used:
Sprout-Waldron mills are made by Andritz Sprout-Bauer, Inc., Muncy, PA 17756, USA
Bantam® Mikro pulverizer was made by Division of MikroPul, United States Filter Corp. Summit, NJ 07901, USA
Ahlstrom Master Screen F1 was made by Ahlstrom Machinery Corp., FIN-48601, Kaphula, Finland
Mean length of LCP pulp was determined on the Fiber Quality Analyzer (OpTest Equipment, Inc.,900 Tupper Street, Hawkesbury, Ontario, Canada K6A353)

### Example 1

Strand cut pellets of LCP were ground in a 30.5 cm diameter Sprout-Waldron model 12-2C-2976-A single rotating disc refiner equipped with plates in one pass with the gap between plates of about 25 µm, a feed speed of about 60 g/min. and continuous addition of water in quantity of about 4 kg of water per 1 kg of the pellets. The resulting LCP pulp was additionally ground in a Bantam® Mikro Pulverizer, Model CF, to pass through a 30 mesh screen. The final pulp had arithmetic, length weighted, and weight weighted mean lengths of 0.21, 0.65, and 1.40 mm respectively.

### Example 2

The LCP used had the composition of the LCP of Example 9 of U.S. Patent 5,110,896, hydroquinone/4,4'-biphenol/terephthalic acid/2,6-naphthalenedicarboxylic acid/4-hydroxybenzoic acid in molar ratio 50/50/85/15/320. The particulate LCP was prepared by grinding a melt blend of LCP (70 wt. %) and a polytetrafluoroethylene powder (30 wt. %) in a Bantam® Mikro Pulverizer (model CF) along with liquid nitrogen until the particles passed through about a 10 mesh screen. The particles were reground in the same unit with additional liquid nitrogen until they passed through a 40 mesh screen.

### Example 3

Strand cut pellets of LCP were ground on 30.5 cm diameter Sprout-Waldron type double disc refiner model 12-2, equipped with plates type C-2976-Ain one pass using an interdisc gap of 25 µm, feeding speed of about 60 g/min. and continuous addition of water in quantity of about 4 kg of water per 1 kg of the pellets. This LCP pulp was additionally ground (without removing the water from the first step) with about an additional 1 kg water/kg dry product in a Bantam® Mikro Pulverizer, Model CF, to pass through a 60 mesh screen. Final pulp had arithmetic, length weighted, and weight weighted mean lengths of 0.18, 0.39, and 0.86 mm respectively.

### Example 4

The 40 mesh particulate LCP was prepared by rough grinding an LCP having the composition of Example 9 of U.S. Patent 5,110,896 of hydroquinone/4,4'-biphenol/terephthalic acid/2,6-naphthalenedicarboxylic acid/4-hydroxybenzoic acid in molar ratio 50/50/85/15/320, and which also contained 30% by weight glass fiber, and was in the form of resin pellets (right circular cylinders approximately 1/8" in diameter and length) in a Bantam® Mikro Pulverizer, Model CF, with liquid N₂ also present, and with a coarse (about 10 mesh) discharge screen. The course cut resin was then placed back in the Bantam® Mikro Pulverizer, Model CF, with additional liquid N₂ until the final product passed through a 40 mesh screen.

### Example 5

Pellets of LCP were ground in a 91.4 cm diameter Sprout-Waldron Model 36-2 single rotating disc refiner with equipped with plates type 16808, with a gap between plates of about 0.73 mm, at feeding speed of about 1.5 kg/min., with addition of about 98.8 kg of water per kg of the pellets. After a first pass, pulp produced was diluted to consistency of about 0.8 wt.% and ground a second time with double recirculation of the slurry through the refiner at gap between discs of about 0.25 mm. Refined LCP pulp was screened through an Ahlstrom F1 Master Screen with slots 0.36 mm wide (about 45 mesh). Final pulp had arithmetic, length weighted, and weight weighted mean lengths of 0.14, 0.45, and 1.82 mm respectively.

## Claims

1. A grinding process for forming small particles from larger particles of an anisotropic thermotropic liquid crystalline polymer, comprising
(a) a first grinding stage wherein said anisotropic thermotropic liquid crystalline polymer is ground in a first grinding apparatus;
(b) removing said anisotropic thermotropic liquid crystalline polymer from said first grinding apparatus;
(c) a second grinding stage wherein said anisotropic thermotropic liquid crystalline polymer from (b) is ground in a second grinding apparatus; and
(d) removing said anisotropic thermotropic liquid crystalline polymer from said second grinding apparatus.

2. The process as recited in claim 1 wherein said thermotropic liquid crystalline polymer contains one or more other ingredients.

3. The process as recited in claim 1 wherein said thermotropic liquid crystalline polymer is a blend with one or more other polymers.

4. The process as recited in claim 1 wherein said thermotropic liquid crystalline polymer is classified after one or more of said first grinding stage and said second grinding stage.

5. The process as recited in claim 1 wherein said grinding is done dry.

6. The process as recited in claim 1 wherein said grinding is done wet.

7. The process as recited in claim 1 wherein at least about 90 weight percent of a product of (d) passes through a 30 mesh screen.

8. The process as recited in claim 1 wherein at least about 90 weight percent of a product of (d) passes through a 60 mesh screen.

9. The process as recited in claim 1 herein said thermotropic liquid crystalline polymer is an aromatic polyester.

10. The process as recited in claim 1 additionally comprising one or more additional grinding stages.

11. The process of claim 1 wherein said first grinding apparatus and said second grinding apparatus are the same or different.

## Patentansprüche

1. Verfahren zum Mahlen zum Erzeugen kleiner Partikel aus größeren Partikeln eines anisotropen, thermotropen, flüssigkristallinen Polymers, umfassend:
(a) eine erste Mahlstufe, worin das anisotrope, thermotrope, flüssigkristalline Polymer in einem ersten Mahlapparat gemahlen wird;
(b) Entfernen des anisotropen, thermotropen, flüssigkristallinen Polymers aus dem ersten Mahlapparat;
(c) eine zweite Mahlstufe, worin das anisotrope, thermotrope, flüssigkristalline Polymer von (b) in einem zweiten Mahlapparat gemahlen wird und
(d) Entfernen des anisotropen, thermotropen, flüssigkristallinen Polymers aus dem zweiten Mahlapparat.

2. Verfahren nach Anspruch 1, worin das thermotrope, flüssigkristalline Polymer einen oder mehrere andere Bestandteile enthält.

3. Verfahren nach Anspruch 1, bei welchem das thermotrope, flüssigkristalline Polymer ein Blend mit einem oder mehreren anderen Polymeren ist.

4. Verfahren nach Anspruch 1, bei welchem das thermotrope, flüssigkristalline Polymer nach einer oder mehreren der ersten Mahlstufe und der zweiten Mahlstufe klassiert wird.

5. Verfahren nach Anspruch 1, bei welchem das Mahlen trocken erfolgt.

6. Verfahren nach Anspruch 1, bei welchem das Mahlen nass erfolgt.

7. Verfahren nach Anspruch 1, bei welchem mindestens etwa 90 Gew.% eines Produktes von (d) ein 30 Mesh-Sieb passieren.

8. Verfahren nach Anspruch 1, bei welchem mindestens etwa 90 Gew.% eines Produktes von (d) ein 60 Mesh-Sieb passieren.

9. Verfahren nach Anspruch 1, bei welchem das thermotrope, flüssigkristalline Polymer ein aromatischer Polyester ist.

10. Verfahren nach Anspruch 1, zusätzlich umfassend eine oder mehrere zusätzliche Mahlstufen.

11. Verfahren nach Anspruch 1, bei welchem der erste Mahlapparat und der zweite Mahlapparat gleich oder verschieden sind.

## Revendications

1. Procédé de broyage pour former de petites particules à partir de plus grandes particules d'un polymère cristallin liquide thermotrope anisotrope, comprenant:
(a) un premier stade de broyage dans lequel ledit polymère cristallin liquide thermotrope anisotrope est broyé dans un premier appareil de broyage;
(b) le retrait dudit polymère cristallin liquide thermotrope anisotrope dudit premier appareil de broyage;
(c) un second stade de broyage dans lequel ledit polymère cristallin liquide thermotrope anisotrope à partir de (b) est broyé dans un second appareil de broyage; et
(d) le retrait dudit polymère cristallin liquide thermotrope anisotrope dudit second appareil de broyage.

2. Procédé tel qu'énoncé dans la revendication 1, dans lequel ledit polymère cristallin liquide thermotrope contient un ou plusieurs autre(s) ingrédient(s).

3. Procédé tel qu'énoncé dans la revendication 1, dans lequel ledit polymère cristallin liquide thermotrope est un mélange avec un ou plusieurs autre(s) polymère(s).

4. Procédé tel qu'énoncé dans la revendication 1, dans lequel ledit polymère cristallin liquide thermotrope est classé après un ou plusieurs dudit premier stade de broyage et dudit second stade de broyage.

5. Procédé tel qu'énoncé dans la revendication 1, dans lequel ledit broyage est effectué à sec.

6. Procédé tel qu'énoncé dans la revendication 1, dans lequel ledit broyage est effectué à l'état humide.

7. Procédé tel qu'énoncé dans la revendication 1, dans lequel au moins environ 90 pour cent en poids d'un produit de (d) passent à travers un crible de 30 mesh.

8. Procédé tel qu'énoncé dans la revendication 1, dans lequel au moins environ 90 pour cent en poids d'un produit de (d) passe à travers un crible de 60 mesh.

9. Procédé tel qu'énoncé dans la revendication 1, dans lequel ledit polymère cristallin liquide thermotrope est un polyester aromatique.

10. Procédé tel qu'énoncé dans la revendication 1, comprenant de manière supplémentaire un ou plusieurs stade(s) supplémentaire(s) de broyage.

11. Procédé selon dans la revendication 1, dans lequel ledit premier appareil de broyage et ledit second appareil de broyage sont identiques ou différents.
